# EUROPEAN PATENT APPLICATION

(11) **EP 2 642 337 A1**
(43) Date of publication of application: **25.09.2013**
(21) Application number: 12184710.7
(22) Date of filing: 17.09.2012
(51) Int. Cl.: G02F 1/1333

(54) **Display panel and display apparatus having the same**

(30) Priority: 20.03.2012 KR 20120028501
(71) Applicant: Samsung Electronics Co., Ltd., Gyeonggi-do 443-742 (KR)
(72) Inventor: Shon, Young-ki, Hwaseong-si, Gyeonggi-do (KR)
(74) Representative: Misselbrook, Paul

(57) **Abstract**

A display panel (1) having a protective film (150) which is adhered to the front surface of a panel body (100) by an adhesive (180). The rear surface of the protective film (150) includes convex portions (182) and concave portions (186) which are formed alternately.

## Description

### CROSS-REFERENCE TO RELATED APPLICATION

This application claims priority from Korean Patent Application No. 10-2012-0028501, filed on March 20, 2012 in the Korean Intellectual Property Office, the disclosure of which is incorporated herein by reference in its entirety.

### BACKGROUND

### 1. Field

Methods and apparatuses consistent with exemplary embodiments relate to a display panel and a display apparatus having the same, and more particularly, to a display panel which includes a protective film having improved strength, and a display apparatus having the same.

### 2. Description of the Related Art

A flat panel display (FPD), which is a slim and light image display apparatus, has recently become the most common type of display apparatus. The representative FPD includes a plasma display panel (PDP), a liquid crystal display (LCD), a light emitting diode (LED), and an organic light emitting diode (OLED). The FPD is being used in various products such as a television, a monitor, a camera, a navigation system, and a game machine.

The FPD is vulnerable to external impact due to its thin thickness. To solve this problem, a protective film for enhancing impact resistance may be attached to a display panel of the FPD. A polyethylene terephthalate (PET) film may be used as the protective film.

However, if external impact is applied to the protective film of the related-art FPD, impact strength is concentrated in a direction in which the impact is applied and therefore most of the amount of the impact is transmitted to the display panel, and thus there is a problem in that the display panel is easily damaged.

Various attempts to solve this problem have been made. For example, the related-art FPD employs a plurality of protective films or adds an extra impact resistance layer to the protective film.

However, these protective films or additional impact resistance layers may increase the film manufacturing cost and may complicate the film manufacturing process.

### SUMMARY

One or more exemplary embodiments may overcome the above disadvantages and other disadvantages not described above. However, it is understood that one or more exemplary embodiment are not required to overcome the disadvantages described above, and may not overcome any of the problems described above.

One or more exemplary embodiments provide a display panel which includes a protective film having improved strength, and a display apparatus having the same.

According to an aspect of an exemplary embodiment, there is provided a display panel including: a panel body, and a protective film which is adhered to a front surface of the panel body by an adhesive, wherein a rear surface of the protective film adhered to the panel body includes a convex portion and a concave portion which are formed alternately.

The adhesive may be maintained in a gel state.

The protective film may be made of an elastic material.

The protective film may be made of polyethylene terephthalate (PET).

A cross section of the convex portion of the rear surface of the protective film and the concave portion of the rear surface of the protective film may have one of round, triangular, quadrangular, and trapezoidal shapes.

Each of the convex portion and the concave portion of the rear surface of the protective film may be extended in a lengthwise direction of the display panel.

Each of the convex portion and the concave portion of the rear surface of the protective film may be extended in a width direction of the display panel.

Each of the convex portion and the concave portion of the rear surface of the protective film may be extended in a diagonal direction of the display panel.

The adhesive may be a pressure sensitive adhesive (PSA).

The PSA may be a color PSA.

The display panel may further include a hard coating layer which is formed on a front surface of the protective film.

The display panel may be one of a PDP panel, an LCD panel, an LED panel, and an OLED panel.

According to an aspect of an exemplary embodiment, there is provided a display apparatus including the above-described display panel.

According to the various exemplary embodiments described above, when external impact is applied to the display panel, the impact strength is dispersed by the elastic deformation of the convex portions and the concave portions formed on the protective film so that damage of the display panel can be prevented.

### BRIEF DESCRIPTION OF THE DRAWING FIGURES

The above and/or other aspects will be more apparent by describing in detail exemplary embodiments, with reference to the accompanying drawings, in which:

FIG. 1 is an exploded perspective view schematically illustrating a display apparatus according to an exemplary embodiment;

FIG. 2 is a schematic cross section view of a display panel included in the display apparatus of FIG. 1;

FIG. 3 is a perspective view schematically illustrating a protective film included in the display panel of FIG. 2;

FIG. 4 is an enlarged cross section view of portion 'A' of FIG. 2;

FIGS. 5 and 6 are views schematically illustrating the display panel of FIG. 2 when external impact is applied to the display panel;

FIG. 7 is a schematic cross section view of a display panel according to a second exemplary embodiment;

FIG. 8 is an enlarged cross section view of portion 'A' of FIG. 7;

FIG. 9 is a cross section view schematically illustrating a display panel according to a third exemplary embodiment;

FIG. 10 is a cross section view schematically illustrating a display panel according to a fourth exemplary embodiment;

FIG. 11 is a cross section view schematically illustrating a display panel according to a fifth exemplary embodiment; and

FIG. 12 is a perspective view schematically illustrating a protective film according to an alternative exemplary embodiment.

### DETAILED DESCRIPTION OF EXEMPLARY EMBODIMENTS

Hereinafter, exemplary embodiments will be described in greater detail with reference to the accompanying drawings.

In the following description, same reference numerals are used for the same elements when they are depicted in different drawings. The matters defined in the description, such as detailed construction and elements, are provided to assist in a comprehensive understanding of exemplary embodiments. Thus, it is apparent that exemplary embodiments can be carried out without those specifically defined matters. Also, functions or elements known in the related art are not described in detail since they would obscure the exemplary embodiments with unnecessary detail.

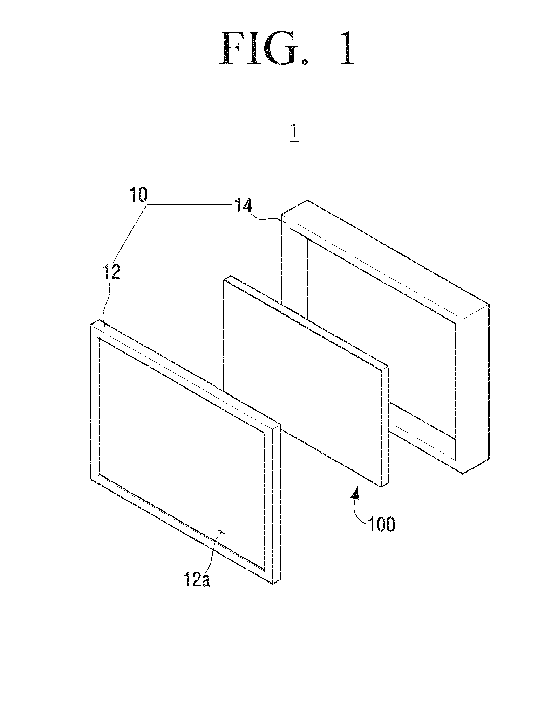

FIG. 1 is an exploded perspective view schematically illustrating a display apparatus according to an exemplary embodiment.

Referring to FIG. 1, a display apparatus 1 includes a housing 10 and a display panel 100.

The display apparatus 1 is a PDP television which is one of the flat panel displays. In an alternative embodiment, the display apparatus 1 may be other flat panel displays such as an LCD television, an LED television, and an OLED television. The display apparatus 1 may be a computer monitor to which such a flat panel display is applied.

The housing 10 contains the display panel 100 and various parts of the display apparatus 1 such as a control board (not shown) to control an operation of the display panel 100 and a power board (not shown) to supply power to the display panel 100.

The housing 10 includes a front housing 12 and a rear housing 14 which are removably connected to each other. The front housing 12 forms a front edge of the display apparatus 1 and has a rectangular opening 12a to allow an image to be exposed to the outside. The rear housing 14 has a receiving space formed therein to receive the aforementioned various parts.

The display panel 100 is a PDP. The PDP is a panel that creates or forms an image by emitting a fluorescent substance using a gas discharge phenomenon and is a representative one of the flat panel display panel. In an alternative embodiment, if the display apparatus 1 is a flat panel display other than the PDP, the display apparatus 1 may include a corresponding display panel. For example, an LCD panel, an LED panel, or an OLED panel may be provided in the display apparatus 1.

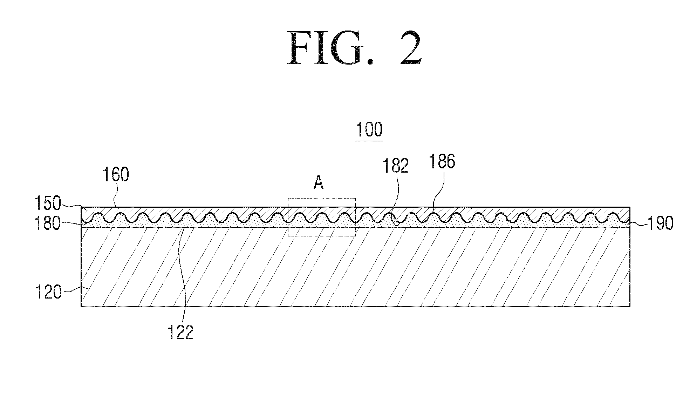

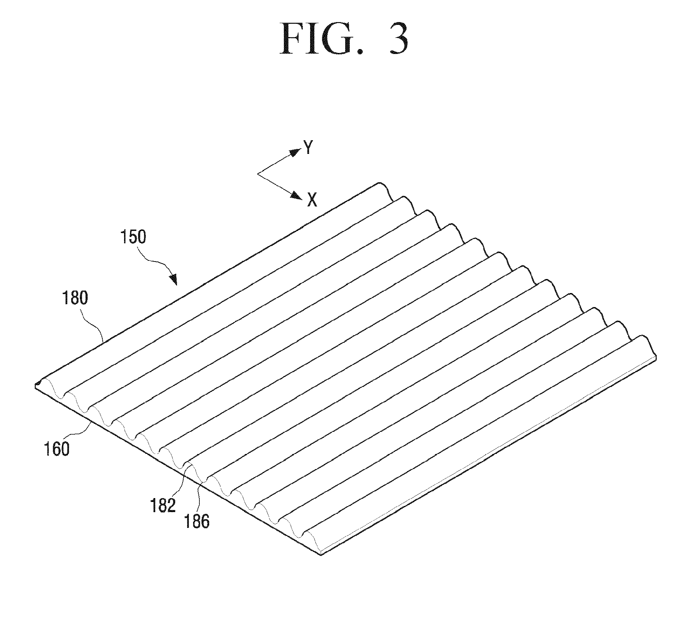

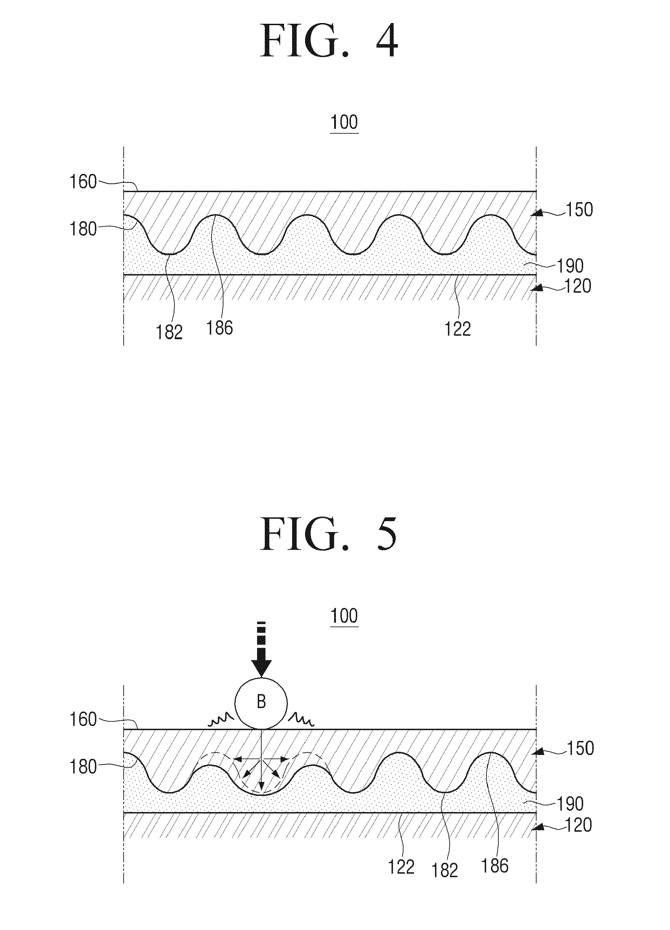

FIG. 2 is a schematic cross section view of the display panel provided in the display apparatus of FIG. 1, FIG. 3 is a perspective view schematically illustrating a protective film provided in the display panel of FIG. 2, and FIG. 4 is an enlarged cross section view of portion 'A' of FIG. 2.

Referring to FIGS. 2 to 4, the display panel 100 includes a panel body 120 and a protective film 150.

Although the panel body 120 is illustrated as a single substrate in FIG. 2, the panel body 120 may include a pair of substrates (not shown) as in a general PDP. A plurality of discharge cells (not shown) corresponding to pixels are formed between the pair of substrates (not shown), and each discharge cell emits a fluorescent substance due to ultraviolet rays generated by gas discharge, so that visually identifiable visible rays are generated. The principle of realizing an image of the PDP is well known and thus a detailed description is omitted.

The protective film 150 is adhered to a front surface 122 of the panel body 120 by an adhesive 190. The protective film 150 protects the panel body 120 from external impact. If the panel body 120 is damaged, the protective film 150 prevents broken pieces from being scattered to the front of the display apparatus 1.

A front surface 160 of the protective film 150 is exposed to the front of the display apparatus 1 and has a flat surface. A rear surface 180 of the protective film 150 is adhered to the front surface 122 of the panel body 120 using the adhesive 190, and includes a plurality of convex portions 182 and a plurality of concave portions 186 unlike the front surface 160.

The convex portions 182 and the concave portions 186 are formed alternately. That is, concave portions 186 are formed at opposite sides of one convex portion 182 and convex portions 182 are formed at opposite sides of one concave portion 186. As shown in FIG. 3, the convex portions 182 and the concave portions 186 are extended in a lengthwise direction (Y) of the protective film 150. That is, the convex portions 182 and the concave portions 186 are extended in a lengthwise direction of the display panel 100, and the convex portions 182 are parallel to one another and the concave portions 186 are also parallel to one another. In an alternative embodiment, the convex portions and the concave portions may be extended in a width direction of the display panel (in an X direction of FIG. 3).

A cross section of each of the convex portion 182 and the concave portion 186 has a round shape having a substantially semi-circular shape. In an alternative exemplary embodiment, the cross section of the convex portion 182 and the concave portion 186 may have a semi-oval shape.

The protective film 150 is made of polyethylene terephthalate (PET). The polyethylene terephthalate is a thermo-plastic resin and is an elastic material that is heat-resistant and has good elasticity. Thus, the protective film 150 is elastically deformable. In an alternative embodiment, the protective film 150 may be made of other elastic materials which are elastically deformable.

If the display panel 100 receives an external impact, the protective film 150 is elastically deformed to absorb the external impact in part or in whole and to mitigate the impact on the panel body 120.

The adhesive 190 may be a pressure sensitive adhesive (PSA). The PSA refers to an adhesive that makes two objects adhere to each other with light pressure. In an alternative embodiment, the adhesive 190 may be a color PSA to which an optical function is added. The color PSA has an optical function in addition to its original adhering function, and, if the color PSA is applied to the PDP, it is possible to shield neon emission and absorb near-infrared ray. An adhesive other than the PSA may be used.

The adhesive 190 is maintained in a gel state after adhering. The gel is a solidified colloid liquid like a jelly and refers to a liquid lump having viscosity. The adhesive 190 being maintained in the gel state enables the convex portions 182 and the concave portions 186 to be elastically deformed. Also, the adhesive 190 being maintained in the gel state may absorb the external impact applied to the display panel 100.

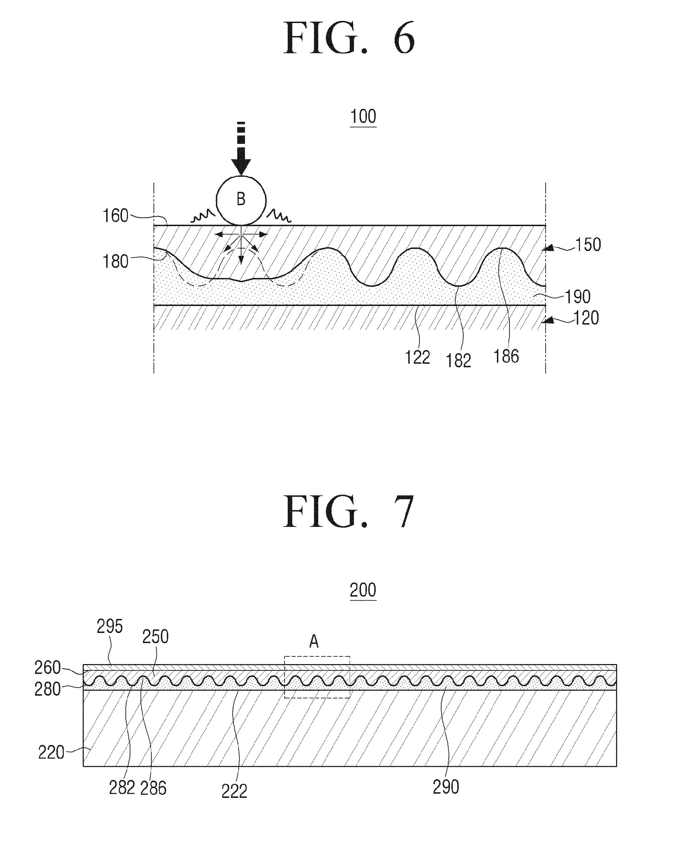

FIGS. 5 and 6 are views schematically illustrating the display panel of FIG. 2 when the display panel receives an external impact.

Referring to FIG. 5, if the front of the display panel 100 receives an external impact (a ball B shown in FIG. 5), the strength of the impact is dispersed in the arrow directions due to the presence of the convex portions 182 and the concave portions 186. The protective film 150 also suffers elastic deformation. The elastic deformation occurs not only in the convex portion 182 in which the impact is directly received, but also in the concave portions 186 formed at opposite sides of the convex portion 182 due to the dispersion of forces. That is, the external impact is absorbed by not only the elastic deformation of the convex portion 182 to which the impact is directly applied, but also the elastic deformation of the concave portions 186 formed at the opposite sides of the convex portion 182.

Referring to FIG. 6, if the display panel 100 receives an external impact (a ball (B) shown in FIG. 6), the strength of the impact is dispersed in the arrow directions similarly as shown in FIG. 5 due to the presence of the convex portions 182 and the concave portions 186. The protective film 150 is also elastically deformed. In FIG. 6, since the external impact is applied in a direction toward the concave portions 186, larger elastic deformation occurs in the concave portions 186. Meanwhile, the convex portions 182 formed at opposite sides of the concave portion 186 contract. That is, even if the external impact is applied in the direction toward the concave portion 186, the external impact is absorbed by not only the elastic deformation of the concave portions 186, to which the impact is directly applied, but also by the elastic deformation of the convex portions 182 formed at the opposite sides of the concave portion 186.

As shown in FIGS. 5 and 6, if the display panel 100 receives an external impact, the protective film 150 disperses and absorbs the impact using the elastic deformation of the convex portions 182 and the concave portions 186. The elastic deformation is possible because the adhesive 190 is maintained in the gel state as described above.

The adhesive 190 also absorbs the external impact as described above. Due to the presence of the convex portions 182, the concave portions 186, and the adhesive 190, the panel body 120 of the display panel 100 may not be subjected to the external impact or the effect of the impact may be reduced.

As described above, without adding a separate member to improve impact resistance to the protective film 150, the display panel 100 can improve the strength of the protective film 150. Therefore, there is no need to increase the thickness of the display panel 100 since the thickness of the protective film 100 is not increased, and thus, the display panel 100 can still be made slim, a manufacturing cost of the protective film 100 can be reduced, and a manufacturing process of the protective film 100 can be simplified.

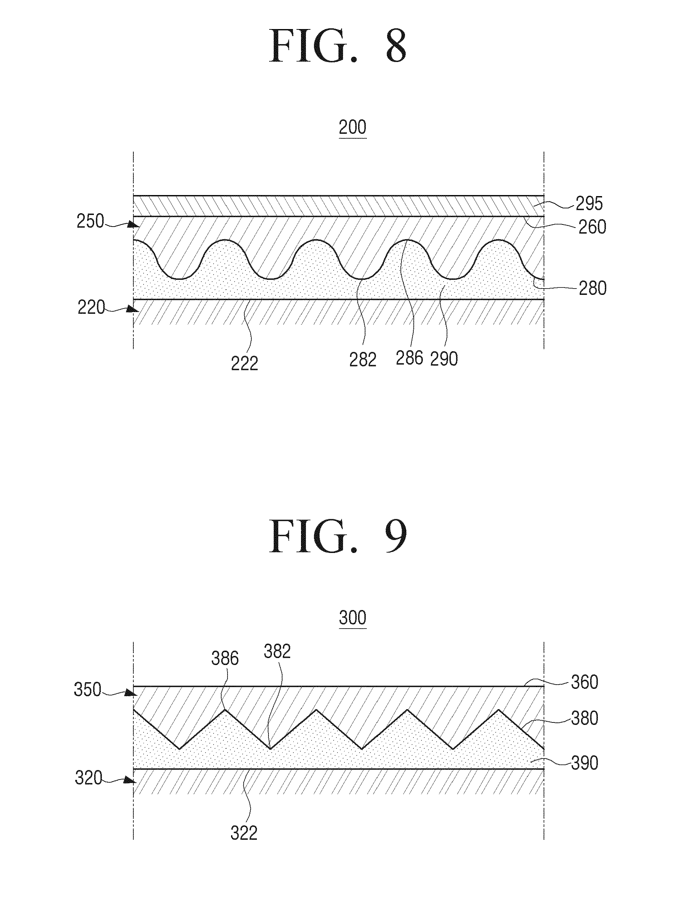

FIG. 7 is a schematic cross section view of a display panel according to a second exemplary embodiment, and FIG. 8 is an enlarged view of portion 'A' of FIG. 7.

A display panel 200 according to a second exemplary embodiment is similar to the display panel 100 of the aforementioned embodiment. For instance, a panel body 220, a front surface 222 of the panel body 220, a rear surface 280 of a protective film 250, a convex portion 282 of the protective film 250, and a concave portion 286 of the protective film 250 are the same as those of the above-described display panel 100. An adhesive 290 is also the same as the aforementioned adhesive 190. Therefore, these elements are not explained repeatedly.

Referring to FIGS. 7 and 8, the display panel 200 includes a hard coating layer 295.

The hard coating layer 295 is formed on a front surface 260 of the protective film 250 and thus is exposed to the front of the display apparatus. The hard coating layer 295 performs an optical function of preventing specular reflection or diffuse reflection of light. Accordingly, the display panel 200 according to the present exemplary embodiment can provide a clearer and high quality image for a user by using the hard coating layer 295.

Also, since the hard coating layer 295 is further exposed to the front side of the display apparatus than the protective film 250, the hard coating layer 295 can protect the protective film 250 from scratch caused by external impact.

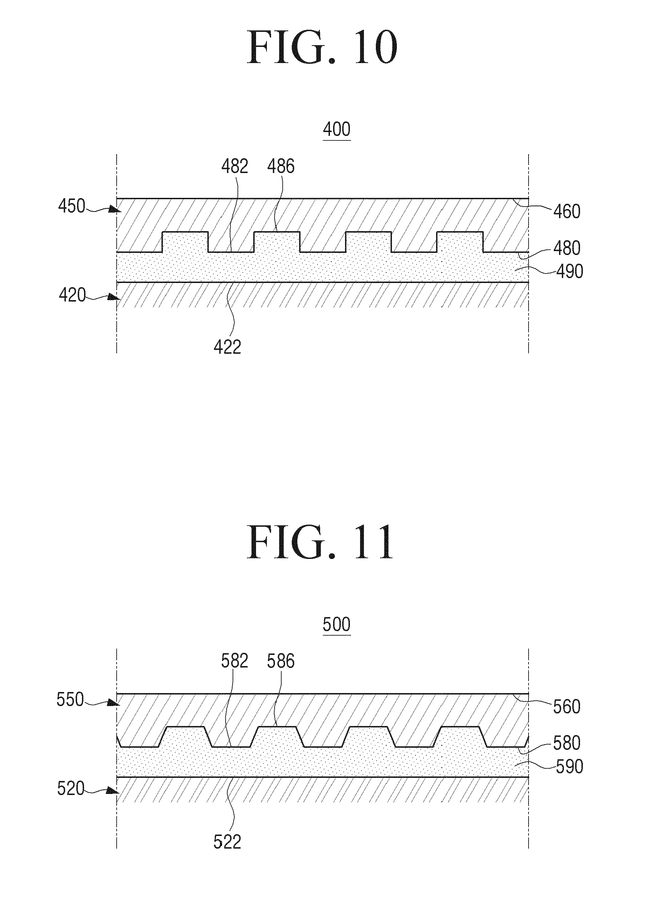

FIG. 9 is a cross section view schematically illustrating a display panel according to a third exemplary embodiment, FIG. 10 is a cross section view schematically illustrating a display panel according to a fourth exemplary embodiment, and FIG. 11 is a cross section view schematically illustrating a display panel according to a fifth exemplary embodiment.

Display panels 300, 400, and 500 according to the third to the fifth exemplary embodiments are similar to the display panel 100 of the aforementioned exemplary embodiment. For instance, panel bodies 320, 420, and 520, front surfaces 322, 422, and 522 of the panel bodies 320, 420, and 520, and front surfaces 360, 460, and 560 of the protective films 350, 450, and 550 are the same as those corresponding elements of the display panel 100 described above. Adhesives 390, 490, and 590 are also the same as the adhesive 190 described above. Therefore, these elements are not explained repeatedly.

Rear surfaces 380, 480, and 580 of the protective films 350, 450, and 550 are generally similar to the rear surface 180 of the protective film 150 described above. Hereinafter, a difference between the rear surfaces 380, 480, 580 and the rear surface 180 of the protective film 150 will be mainly explained.

Referring to FIGS. 9 to 11, a cross section of a convex portion 382 and a concave portion 386 of the protective film 350 according to the third exemplary embodiment has a substantially triangular shape. The triangular shape may be an equilateral triangle or an isosceles triangle. A cross section of a convex portion 482 and a concave portion 486 of the protective film 450 according to the fourth exemplary embodiment has a substantially quadrangular shape. The quadrangular shape may be a square or a rectangle. A cross section of a convex portion 582 and a concave portion 586 of the protective film 550 according to the fifth exemplary embodiment has a substantially trapezoidal shape. In an alternative embodiment, the cross section of the convex portion and the concave portion may have other polygonal shapes or saw-toothed shape.

However, it is noted that the cross section shapes of the convex and concave portions of the protective film are not limited to those described above.

In the third to the fifth exemplary embodiments, if the display panels 300, 400, and 500 receive an external impact or an external impact is applied thereto, the convex portions 382, 482, and 582 and the concave portions 386, 486, and 586 absorb the external impact through elastic deformation and mitigate the impact on the panel bodies 320, 420, and 520.

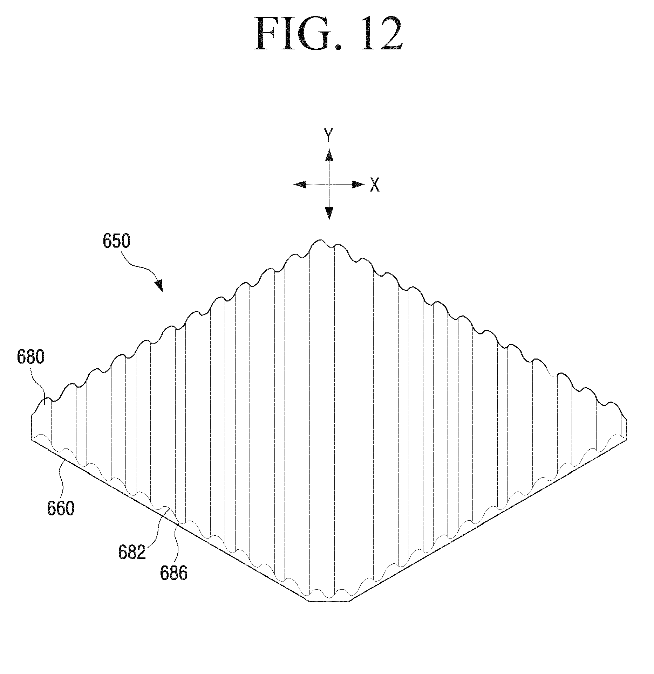

FIG. 12 is a perspective view schematically illustrating a protective film according to an alternative embodiment.

A protective film 650 is similar to the protective film 150 described above.

A rear surface 680 of the protective film 650 includes a plurality of convex portions 682 and a plurality of concave portions 686. As in the above exemplary embodiments, the convex portions 682 and the concave portions 686 are formed alternately. Each of the convex portions 682 and the concave portions 686 is extended in a diagonal direction (Y) of the protective film 650. That is, the convex portions 682 and the concave portions 686 are extended in the diagonal direction of a display panel (not shown). The convex portions 682 are parallel to one another and the concave portions 686 are also parallel to one another. In an alternative embodiment, the convex portions and the concave portions may be extended in the other diagonal direction (an X direction in FIG. 12).

The protective film 650 is different from the protective film 150 of the aforementioned embodiment in the extending direction of the convex portions 682 and the convex portions 686, but has the same function as that of the protective film 150. That is, if the protective film 650 is provided in the display panel, the impact on the panel body can be mitigated.

The foregoing exemplary embodiments and advantages are merely exemplary and are not to be construed as limiting the present inventive concept. The exemplary embodiments can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. A display panel comprising:
a panel body; and
a protective film which is adhered to a front surface of the panel body by an adhesive,
wherein a rear surface of the protective film adhered to the panel body comprises a convex portion and a concave portion which are formed alternately.

2. The display panel as claimed in claim 1, wherein the adhesive is maintained in a gel state.

3. The display panel as claimed in claim 1, wherein the protective film is made of an elastic material.

4. The display panel as claimed in claim 3, wherein the protective film is made of polyethylene terephthalate (PET).

5. The display panel as claimed in claim 1, wherein a cross section of the convex portion and the concave portion of the rear surface of the protective film has one of round, triangular, quadrangular, and trapezoidal shapes.

6. The display panel as claimed in claim 1, wherein each of the convex portion and the concave portion of the rear surface of the protective film is extended in a lengthwise direction of the display panel.

7. The display panel as claimed in claim 1, wherein each of the convex portion and the concave portion of the rear surface of the protective film is extended in a width direction of the display panel.

8. The display panel as claimed in claim 1, wherein each of the convex portion and the concave portion of the rear surface of the protective film is extended in a diagonal direction of the display panel.

9. The display panel as claimed in claim 1, wherein the adhesive is a pressure sensitive adhesive (PSA).

10. The display panel as claimed in claim 9, wherein the PSA is a color PSA.

11. The display panel as claimed in claim 1, further comprising a hard coating layer which is formed on a front surface of the protective film.

12. The display panel as claimed in claim 1, wherein the display panel is one of a plasma display panel (PDP) panel, a liquid crystal display (LCD) panel, a light emitting diod (LED) panel, and an organic light emitting diode (OLED) panel.

13. A display apparatus comprising a display panel according to any one of claims 1 to 12.

## Amended claims

### Amended claims in accordance with Rule 137(2) EPC.

**1.** A display panel comprising:
a panel body; and
a protective film which is adhered to a front surface of the panel body by an adhesive,
wherein a rear surface of the protective film adhered to the panel body comprises a convex portion and a concave portion which are formed alternately.

**2.** The display panel as claimed in claim 1, wherein the adhesive is maintained in a gel which is a jelly like colloid liquid.

**3.** The display panel as claimed in claim 1 or claim 2, wherein the protective film is made of an elastic material.

**4.** The display panel as claimed in claim 3, wherein the protective film is made of polyethylene terephthalate (PET).

**5.** The display panel as claimed in claim 1, wherein a cross section of the convex portion and the concave portion of the rear surface of the protective film has one of round, triangular, quadrangular, and trapezoidal shapes.

**6.** The display panel as claimed in claim 1, wherein each of the convex portion and the concave portion of the rear surface of the protective film is extended in a lengthwise direction of the display panel.

**7.** The display panel as claimed in claim 1, wherein each of the convex portion and the concave portion of the rear surface of the protective film is extended in a width direction of the display panel.

**8.** The display panel as claimed in claim 1, wherein each of the convex portion and the concave portion of the rear surface of the protective film is extended in a diagonal direction of the display panel.

**9.** The display panel as claimed in claim 1, wherein the adhesive is a pressure sensitive adhesive (PSA).

**10.** The display panel as claimed in claim 9, wherein the PSA is a color PSA.

**11.** The display panel as claimed in claim 1, further comprising a hard coating layer which is formed on a front surface of the protective film.

**12.** The display panel as claimed in claim 1, wherein the display panel is one of a plasma display panel (PDP) panel, a liquid crystal display (LCD) panel, a light emitting diod (LED) panel, and an organic light emitting diode (OLED) panel.

**13.** A display apparatus comprising a display panel according to any one of claims 1 to 12.
